# EUROPEAN PATENT SPECIFICATION

(11) **EP 2 275 591 B1**
(45) Date of publication and mention of the grant of the patent: **19.03.2014**
(21) Application number: 09165215.6
(22) Date of filing: 10.07.2009
(51) Int. Cl.: C30B 23/02, C30B 29/08, C30B 29/02, H01L 21/02

(54) **Method for manufacturing a mono-crystalline layer of germanium or aluminium on a substrate**
Verfahren zur Herstellung einer monokristallinen Schicht aus Germanium oder Aluminium auf einem Substrat
Procédé de fabrication d'une couche monocristalline de germanium ou d'aluminium sur un substrat

(43) Date of publication of application: 19.01.2011
(73) Proprietor: IMEC, 3001 Leuven (BE)
(72) Inventor: Lieten, Ruben, 3520 ZONHOVEN (BE); Degroote, Stefan, 3271 SCHERPENHEUVEL-ZICHEM (BE)
(74) Representative: Pronovem

(56) References cited:
- EP-A- 0 293 232
- EP-A- 0 550 888
- WO-A-2009/013242
- JP-A- 7 045 520
- KAMMLER M ET AL: "Surfactant-mediated epitaxy of Ge on Si: progress in growth and electrical characterization" THIN SOLID FILMS, ELSEVIER-SEQUOIA S.A. LAUSANNE, CH, vol. 336, no. 1-2, 30 December 1998 (1998-12-30), pages 29-33, XP004154048 ISSN: 0040-6090

## Description

### Field of the invention

The present invention is related to methods for producing a mono-crystalline layer on a substrate. A particular application is the deposition of mono- crystalline Ge on mono-crystalline Si, for use in the manufacturing of CMOS devices.

### State of the art

Epitaxial germanium on silicon is useful for extending conventional Si complementary metal-oxide-semiconductor (CMOS) circuits. It can be used to integrate fast germanium photo detectors and modulators on Si CMOS for optical interconnections. Furthermore, germanium shows only a small lattice mismatch with GaAs and can therefore be utilized as a virtual substrate for the integration of III-V devices on Si.

Besides extending conventional Si electronics, epitaxial germanium on silicon can enable the replacement of Si CMOS by Ge electronics for high performance applications. Germanium transistors can be faster, because of the higher carrier mobility. Using bulk germanium substrates for CMOS is not feasible, as there is insufficient material available to cover the market needs. However, by employing only a thin layer of germanium deposited on a suitable substrate, this problem can be avoided. An important advantage of using epitaxial growth of Ge on Si substrates is the scalability: germanium layers of larger diameter can be obtained by simply using larger Si substrates.

Epitaxial growth is mostly utilized to obtain a crystalline layer on top of another crystalline material. However, heteroepitaxial growth of germanium on silicon is rather difficult because of the large mismatch of 4 % between the two lattices.

This difference in lattice dimensions leads to island growth, causing high surface roughness and high density of threading dislocations (TDs) in the Ge layer. Additional annealing or chemical-mechanical-polishing (CMP) steps are often required to reduce the surface roughness. Obtaining high quality and smooth crystalline germanium, directly on silicon, is therefore challenging.

Patent application JP7045520A discloses a method to grow a germanium epitaxial layer without forming an island structure, by individually irradiating a silicon crystal substrate in a vacuum, with a germanium molecular beam and atomic state hydrogen. The growth conditions are altered by supplying atomic H which acts as a surfactant and forms bonds with the substrate and with the germanium atoms in the epitaxial layer. However, when using H₂ plasma, H will be incorporated in the layer during deposition. Moreover, employing this approach needs a plasma source and a pure H₂ supply, with very low amounts of impurities (N₂, O₂, H₂O) in order to prevent their incorporation in the layer.

Patent application WO2004031457A1 describes a method of depositing epitaxial layers based on Group IV elements on a silicon substrate by Chemical Vapor Deposition (CVD), wherein nitrogen or a noble gas is used as carrier gas. CVD makes use of a gas molecule (precursor) which is thermally cracked in the process chamber at a pressure between 10-50 mtorr into different species. Only one of the species is desirable to be incorporated (e.g. Ge). However, other species such as H will also incorporate partially. Moreover, the precursors (e.g. GeH₄) are often toxic gasses which need dedicated safety precautions.

Kammler et al. (Thin Solid Film, 336 (1998) pages 29-33) teach a process for the surfactant-mediated epitaxy of germanium on silicon. In this process Sb surfactant atoms help to produce smooth and relaxed films of germanium produced by molecular beam epitaxy. In EP 0550888 single crystal films of aluminium are produced on silicon substrates by molecular beam epitaxy at low pressure (2.10⁻⁷ Pa).

A solid phase epitaxy method for forming a mono-crystalline germanium layer on mono-crystalline silicon is described in WO2009013242. The method describes solid phase epitaxy of germanium on silicon comprising amorphous germanium deposition by chemical vapor deposition (CVD), plasma enhanced chemical vapor deposition (PECVD), or molecular beam epitaxy (MBE) at a temperature between -196°C and 500°C followed by a thermal anneal at about 600°C, wherein the amorphous germanium deposition is performed in the presence of a hydrogen source and/or a non-reactive gas source. The hydrogen source is a H₂ gas or a hydrogen-plasma and the non-reactive gas is either N₂, or a noble gas, or mixtures thereof. The thermal anneal converts the amorphous germanium to a mono-crystalline material and/or removes the species (i.e. H species) incorporated in the amorphous germanium. The mono-crystalline Ge layer obtained by this method is not completely free of defects. Structural investigation by XRD (X-Ray Diffraction) of the Ge layers prepared according to WO2009013242 still shows the presence of germanium twins. Moreover, this method is complex because of the required annealing step.

The same subject is treated in 'Epitaxial Growth of Nitrides on Germanium', ir. Ruben Lieten, PhD thesis (Chapter 6, pag 93-123), published in 2008 by VUBPRESS, ISBN 978 90 5487 485 0. This study revealed that Ge deposited on a Silicon substrate by thermal evaporation in the presence of a hydrogen (H₂) flux, at temperatures between 300°C and 500°C leads to monocrystalline Ge layers before annealing the substrate. However, it was found that under these circumstances, important levels of hydrogen are incorporated in the crystalline Ge layer.

### Summary of the invention

The invention is related to a method as described in the appended claims. Preferred embodiments are described in combinations of the independent claims with one or more of the dependent claims.

The invention is thus related to a method for growing a layer of a mono-crystalline material on a substrate comprising
- loading a substrate having an exposed area made of a first mono-crystalline material in a process chamber,
- supplying a beam of neutral species of a second material towards the substrate in the presence of a diffusion limiting gas, such that the pressure in the process chamber is between 1x10⁻⁶ torr and 1x10⁻⁴ torr, so that the neutral species of the second material are adsorbed on the exposed area, thereby growing a mono-crystalline layer of said second material overlying and in contact with the first mono-crystalline material
wherein said diffusion limiting gas is a non-reactive gas.

According to an embodiment, the method comprises the steps of
- loading a substrate having an exposed area made of a first mono-crystalline material in a process chamber, thereafter
- introducing said non-reactive diffusion-limiting gas into said chamber, such that the pressure in the process chamber is between 1x10⁻⁶ torr and 1x10⁻⁴ torr,
- supplying a beam of neutral species of the second material towards the substrate so that the neutral species of the second material are adsorbed on the exposed area.

According to another embodiment, the method comprises the steps of
- loading a substrate having an exposed area made of a first mono-crystalline material in a process chamber, thereafter
- supplying a beam of neutral species of the second material towards the substrate so that the neutral species of the second material are adsorbed on the exposed area
- simultaneously with said beam of a neutral species, supplying a flux of said non-reactive diffusion-limiting gas into said chamber, such that the pressure in the process chamber is between 1x10⁻⁶ torr and 1x10⁻⁴ torr.

Before the substrate is loaded into the chamber, and before any of the steps of introducing the diffusion-limiting gas and the neutral species, a background pressure lower than 10⁻⁹ torr may be created in the process chamber.

Said flux of a diffusion-limiting gas may be between 0.1 and 20sccm.

The diffusion limiting gas is a noble gas, molecular N₂, or a mixture thereof.

The beam of neutral species of the second material is formed by evaporation of a source in the process chamber.

The method may comprise cleaning the substrate by growing a layer of the first mono-crystalline material prior to growing the layer of the second mono-crystalline material.

According to an embodiment, the first mono-crystalline material and the second mono-crystalline material are made of the same material.

The first mono-crystalline material may be a semiconductor material of group IV. Alternatively, the first mono-crystalline material may be a III-V compound semiconductor material.

According to a particular embodiment, the second mono-crystalline material is germanium and the growing is performed at a temperature between 300°C and 550°C. Alternatively, the second mono-crystalline material may be aluminium.

The invention is also related to the use of the method of the invention for manufacturing a CMOS device.

### Brief description of the drawings

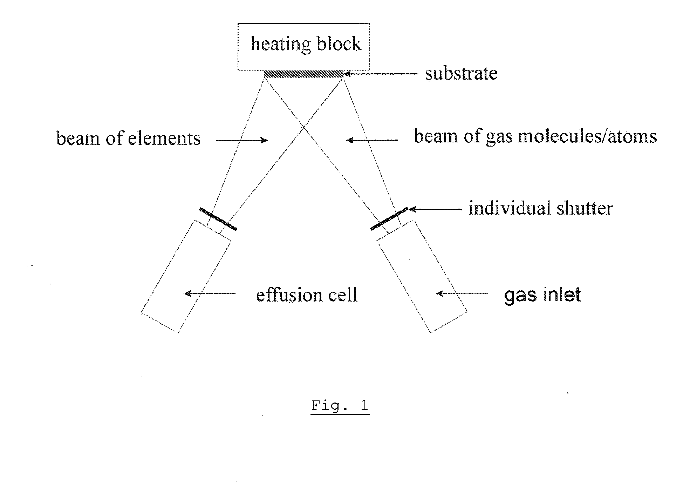

Figure 1 represents schematically the experimental set-up for the epitaxial growth in vacuum of a mono-crystalline material by evaporating a source material to form a beam of neutral species and concurrently supplying a flux of a diffusion limiting gas, according to the invention.

### Detailed description of the invention

The invention discloses a method for growing a layer of a mono-crystalline material on a substrate comprising
- loading a substrate having an exposed area made of a first mono-crystalline material in a process chamber, in the presence of a diffusion limiting gas, such that the pressure in the process chamber is between 1x10⁻⁶ torr and 1x10⁻⁴ torr (1 torr = 133,3 Pa),
- supplying a beam of neutral species of a second material towards the substrate so that the neutral species of the second material are adsorbed on the exposed area, thereby growing a mono-crystalline layer of said second material overlying and in contact with the first mono-crystalline material.
The diffusion limiting gas is not hydrogen originating from a hydrogen source such as e.g. a hydrogen plasma or a H₂ flux. According to the invention, said diffusion limiting gas is a non-reactive gas. The non-reactive gas does not form bonds with the exposed first mono-crystalline material and/or with the adsorbed neutral species (atoms/molecules) of the second material. The non-reactive gas is molecular nitrogen (N₂) or a noble gas (e.g. He, Ar) or a mixture of N₂ and a noble gas.

The present invention reveals that the use of a non-reactive gas as a diffusion limiting gas does not lead to a substantial incorporation of said non-reactive gas into the deposited mono-crystalline layer. In particular, the use of N₂ and/or a noble gas in the deposition according to claim 1, of a Ge layer on a Si-substrate does not lead to a substantial incorporation of N₂ or noble gas components into the deposited monocrystalline Ge-layer. The invention thus allows to obtain high-quality monocrystalline layers on monocrystalline substrates, without requiring an anneal step.

Without anneal, the growth process is simplified. The method is suitable for the growth of smooth mono-crystalline layers with very good crystal quality. Typically a molecular beam epitaxy (MBE) reactor or a similar ultra high vacuum (UHV) process chamber having means for supplying a non-reactive gas are suitable apparatuses to grow the mono-crystalline layer. The means for supplying the non-reactive gas can be a gas inlet provided with a mass flow controller.

Throughout this application, the ultra high vacuum (UHV) conditions refer to the vacuum regime characterized by pressures lower than about 10⁻⁷ Pa or 100 nPa (10⁻⁹ mbar, ∼10⁻⁹ torr). The high vacuum conditions refer to the vacuum regime characterized by pressures between 10⁻⁶ torr and 10⁻⁴ torr.

The high vacuum conditions correspond to the working (growth/deposition) pressure in the presence of the non-reactive gas. The ultra high vacuum conditions correspond to the initial (impurity) background pressure, before introducing the non-reactive gas in the chamber, and before introducing for the first time a substrate into the chamber. It is to be noted that the method of the invention is performed in an apparatus wherein the process chamber can be loaded with a substrate without altering the pressure in said chamber. This can be done by providing a transfer chamber for the substrate, as known in the art. After applying the method to the first substrate, the method can then be applied to subsequent substrates, without bringing the process chamber back to ultra high vacuum, but by keeping the chamber under high vacuum in the presence of the non-reactive gas.

Following the method of the invention a layer-by-layer growth is achieved at least in the beginning of the growth process, during the growth of the first 3-4 monolayers of the second crystalline material.

A layer-by-layer growth is characterized by the fact that the arriving species (atoms) on the substrate form a complete monolayer instead of nucleating locally and forming islands. This growth mode leads to layers of high crystal quality and with smooth surface (low roughness).

The diffusion limiting gas used during growing the layer of the second mono-crystalline material is a gas that lowers the mobility (or limits the diffusion and thereby decreases the surface diffusion length) of the neutral species of the second material on the exposed area by obstructing these neutral species mechanically. In epitaxial growth a reduction in surface mobility is useful to suppress 3D island formation kinetically, at least during the growth of the first few monolayers.

The non-reactive gas is behaving like an inert species that does not form bonds with the exposed first mono-crystalline material and/or with the adsorbed neutral species (atoms/molecules) of the second material.

Examples of non-reactive gasses that may be used with embodiments of the present invention are N₂, noble gasses such as He, Ne, Ar, Kr, Xe and Rn, or mixtures thereof.

The neutral species of the second material are atoms and/or molecules also referred to as elements of the second material originating from a source in the process chamber.

The diffusion limiting gas supplied during growing the layer of the second mono-crystalline material does essentially not incorporate in the second mono- crystalline material, leading therefore to a mono- crystalline material of very high quality.

In various embodiments the beam of neutral species (atoms and/or molecules) of the second material is formed by evaporation of a source in the process chamber. The process chamber is equipped with a source from which materials are evaporated to form a molecular beam. Evaporation can take place either through heating of a source material (Knudsen Cells) or through bombardment of a source material with high energy electrons (E-beam evaporators).

In embodiments of the invention the growth is performed in the process chamber in the presence of the diffusion limiting gas at a pressure between 1x10⁻⁶ torr and 1x10⁻⁴ torr. Throughout the description by pressure in the process chamber is meant the pressure at the substrate position in the process chamber. Before loading the substrate ultra high vacuum (UHV) is created in the process chamber, i.e. an initial (impurity) background pressure lower than 1x10⁻⁹ torr. The impurity background should be kept low to prevent impurities to incorporate into the layer. However, in between two deposition steps on subsequent substrates the process chamber does not have to be pumped down back to the background pressures. Instead, it can be kept under a non-reactive gas, e.g. N₂.

In different embodiments of the invention, the flux of the diffusion limiting gas measured at the gas inlet is between 0.1 and 20 sccm. Preferably, the flux of the diffusion limiting gas is between 0.3 and 15 sccm. More preferably, the flux of the diffusion limiting gas is between 0.6 and 10 sccm. In general, 1 sccm corresponds to 4.5x10¹⁷ molecules/s, that corresponds further for a given experimental configuration with a flux of about 9.9x10¹⁵ at/cm²s in the process chamber.

The evaporation rate of Ge atoms from a Ge-source is between 1x10¹⁴ at/cm²s (100 nm/h) and 5x10¹⁵ at/cm²s. Consequently, the flux of the diffusion limiting gas has to be at least about 1x10¹⁵ at/cm²s or higher in order to achieve an effective lowering of the mobility of the adsorbed Ge atoms.

The above mentioned range of the flux of the diffusion limiting gas corresponds to a pressure in the process chamber during growth between 1x10⁻⁶ torr and 1x10⁻⁴ torr.

In embodiments of the invention, during the step of supplying the beam of neutral species of the second material a diffusion limiting gas is concurrently supplied, such that a pressure in the process chamber is between 1x10⁻⁶ torr and 1x10⁻⁴ torr.

In these embodiments, because the growth takes place in high vacuum (at a pressure between 1x10⁻⁶ torr and 1 x 10⁻⁴ torr), the flow of the neutral species of the second material and the diffusion limiting gas have both a "beam" nature. A beam of neutral species of a second material can be obtained by evaporating a source material. A beam of gas molecules/atoms can be obtained by controlling the flux of a gas inlet.

Figure 1 represents schematically an experimental set-up for the epitaxial growth in vacuum of a mono-crystalline material by evaporating a source material to form a beam of neutral species and concurrently supplying a flux of a diffusion limiting gas.

In alternative embodiments of the invention, a diffusion limiting gas is present already in the process chamber when the growth process begins at a pressure high enough (at least 1x10⁻⁶ torr) to lower the mobility of the atoms on the substrate surface. The diffusion limiting gas can be introduced through a gas inlet before starting the growth process, e.g. before starting the evaporation of the source material.

According to embodiments of the invention, the method further comprises cleaning the substrate prior to growing the layer of the second mono-crystalline material to remove the native oxide, contaminants and/or particles present on the substrate surface.

Cleaning the substrate may be performed by using a wet or a dry chemical cleaning step.

According to embodiments of the invention, cleaning the substrate to remove the native oxide may be performed in-situ in the process chamber by thermal treatment. For a mono-crystalline Si substrate the thermal treatment is performed at a temperature between 900°C and 1100°C, while for a Ge substrate the temperature should be between 400 °C and 900 °C. The thermal treatment can be performed in vacuum or in the presence of H₂, or in the presence of hydrogen plasma.

According to embodiments of the invention, cleaning the substrate may comprise also growing a layer of the first mono-crystalline material in the process chamber prior to growing the second mono-crystalline material.

In particular embodiments of the invention, the first mono-crystalline material and the second mono-crystalline material are made of the same material.

According to embodiments of the invention, the first mono-crystalline material is a semiconductor material of group IV. More specifically the first mono-crystalline material is selected from the group consisting of Si, Ge, Sn and mixtures thereof.

Alternatively, the first mono-crystalline material is a III-V compound semiconductor material or a group III-nitride material, such as e.g. GaN. In some embodiments the first mono-crystalline material is selected from the group consisting of GaAs, InP, InSb and mixtures thereof.

In different embodiments, the second mono-crystalline material is Germanium. The growing of the mono-crystalline Ge layer is performed by molecular beam epitaxy (MBE) at a temperature between 300°C and 550°C and a pressure between 1x10⁻⁶ torr and 1x10⁻⁴ torr.

In yet other alternative embodiments, the second mono-crystalline material is aluminium.

The method may furthermore comprise implanting the second mono-crystalline material with dopant elements. According to embodiments of the invention, provision of the dopant elements may be performed during growing of the second mono-crystalline material. According to alternative embodiments of the invention, provision of the dopant elements may be performed after growing of the second mono-crystalline material.

In one embodiment of the present invention a method for growing a layer of mono-crystalline germanium on a substrate is provided, comprising
- loading a substrate having atop an exposed area made of mono-crystalline silicon in a process chamber, thereafter
- growing a layer of mono-crystalline germanium overlying and in contact with the mono-crystalline silicon by molecular beam epitaxy (MBE) at a temperature between 300°C and 550°C, said growing comprising supplying a beam of Ge atoms towards the substrate by evaporation of a Ge-source in the process chamber so that the Ge atoms are adsorbed on the exposed area, thereby growing a mono-crystalline layer of Ge overlying and in contact with the mono-crystalline Si, wherein supplying said beam of Ge atoms is performed in the presence of a diffusion limiting gas, such that a pressure in the process chamber is between 1x10⁻⁶ torr and 1x10⁻⁴ torr.

In this embodiment the diffusion limiting gas is a noble gas, molecular N₂ or a mixture thereof. As the diffusion limiting gas is not incorporated into the growing film, its influence on the structural ordering can be explained by the fact that it reduces the surface mobility of adsorbed Ge atoms.

The method of the invention can be used to manufacture thin layers of mono-crystalline Ge of high quality on substrates such as mono-crystalline Si, which can be used further to fabricate heterogeneous CMOS devices, having at least one Ge transistor with high mobility and thus improved performance.

The layer of the second mono-crystalline material formed with the method of the invention has a better quality than a similar layer formed by e.g. Solid Phase Epitaxy (SPE) as referred to elsewhere in the description. The better quality refers to a lower number of defects (twins) in the mono-crystalline material and/or to an improved roughness (smoother layer, or lower RMS value). The better quality may also refer to a better crystal quality as quantified elsewhere in the application and/or to a suppression of the relaxation by increasing the critical thickness of the second mono-crystalline material on the first mono-crystalline material. These parameters are important for the performance of a device manufactured using the layer of the second mono-crystalline material as active layer (e.g. channel layer in a MOSFET device).The method of the invention does not include a further anneal which is absolutely mandatory in case of the SPE.

Various embodiments of the invention disclose growing a layer of a second mono-crystalline material on a substrate having atop an exposed first mono-crystalline material, wherein the first and the second mono-crystalline materials are made of different materials or are made of materials having different chemical composition.

In different embodiments of the invention the substrate is a first mono-crystalline material or comprises at least an exposed area made of a first mono-crystalline material. For example, a patterned substrate having exposed areas made of a first mono-crystalline material and areas covered with an amorphous/polycrystalline material (e.g. isolation regions) at the top surface.

The substrate may further comprise bulk Si, sapphire, Silicon on Insulator (SOI), Germanium on Insulator (GeOI), glass, quartz, plastic, metal or any other material suitable as support for a mono-crystalline material. Furthermore, the substrate can be a composite substrate comprising a combination of materials, for example in the form of a layered structure wherein each layer corresponds to a different material.

The substrate should be chosen such that it can withstand the process steps of the method. For example, it should be chosen such that it will not interact or not negatively interfere with the formation or production technique of the layer of second mono-crystalline material. It should be chosen such that it can withstand the process temperature.

### Examples

In the following examples, measurement results are described of roughness, crystal quality and concentration of species other than the mono-crystalline material present in the mono-crystalline layer.

In general, roughness is a measurement of the small-scale variations in the height of a physical surface. This is in contrast to large-scale variations, which may be either part of the geometry of the surface or unwanted 'waviness'. The Root Mean Square (RMS) is a statistical measure of the magnitude of these small-scale variations. The root mean square (RMS) roughness was determined by atomic force microscopy (AFM) or X-Ray Reflectivity (XRR).

The crystal quality was assessed by measuring the full width at half maximum (FWHM) of x-ray diffraction (XRD) peaks representative for the grown mono-crystalline material. A narrow peak (lower FWHM) corresponds to an increase in crystal quality.

The concentration of species other than the mono-crystalline material present in the mono-crystalline layer was measured by Secondary ion mass spectrometry (SIMS). These were relative measurements performed on the mono-crystalline material obtained with the method of the invention with respect to the same mono-crystalline material grown in the absence of the non-reactive gas.

### Experiment 1: The influence of a N₂ gas beam/flux on the epitaxial growth of Ge on Si.

Ge epitaxy on Si(111) has been performed at a substrate temperature of around 400 °C, with and without supply of a N₂ beam. The epitaxial growth without supply of N₂ beam was done at a background pressure of 7x10⁻¹⁰ torr. The growth with supply of N₂ was done at a pressure of 2.5 x 10⁻⁵ torr, with a N₂ flow rate of 1.2 sccm.

The root mean square (RMS) roughness was determined by atomic force microscopy (AFM) on 5.0 µm by 5.0 µm area and the results are summarized in Table 1. The results show clearly that the supply of a N₂ beam during epitaxial growth of Ge on Si limits the surface roughness.

Furthermore reflection high energy electron diffraction (RHEED) measurements show that the relaxation and the consequent roughening of the Ge layer is suppressed. Without N₂ supply the relaxation begins after around 1.0 nm, whereas with N₂ supply around 1.2 nm, which is 1 monolayer more.

The crystal quality, assessed by measuring the full width at half maximum (FWHM) of the ω Ge(111) x-ray diffraction (XRD) peak, is comparable for the thin layers. This indicates that supplying a beam of N₂ during epitaxial growth, did not decrease the crystal quality.

**Table 1. RMS roughness and FWHM of the ω Go(111) XRD peak, for 6 nm Ge grown epitaxially on Si with and without N₂ supply.**

| **Growth** **conditions** | **Ge** **thickness (nm)** | **RMS** **roughness (nm)** | **ω** **Ge(111)** **FWHM (s)** |
|---|---|---|---|
| no N₂ beam | 6 | 2.6 | 356 |
| N₂ beam | 6 | 0.9 | 346 |

### Experiment 2: The influence of a N2 gas beam/flux on the epitaxial growth of thick Ge layers on Si.

The influence of a N₂ gas beam on the epitaxial growth of Ge on Si has been investigated for 200 nm Ge layers.

The root mean square (RMS) roughness was determined by atomic force microscopy (AFM) on 5.0 µm by 5.0 µm area and the results are summarized in Table 2. The supply of an inert N2 beam during epitaxial growth of ∼ 200 nm Ge on Si does not affect the surface roughness significantly.

The crystal quality, assessed by measuring the full width at half maximum (FWHM) of the ω Ge(111) and asymmetric ω Ge(202) x-ray diffraction (XRD) peak, is better for the layer grown under N₂ supply. This indicates that supplying a beam of N₂ during epitaxial growth increases the crystal quality.

Secondary ion mass spectrometry (SIMS) shows a 3 times higher concentration of nitrogen for the layer grown under N₂ supply, compared to the layer grown without supplying N₂. The absolute concentration could not be determined from the measurements, because of a lack of a reference sample. However, the presence of N inside the Ge layer, deposited without supplying N₂, is expected to be low (< 1 x 10¹⁸ cm⁻³). As the nitrogen level in the sample deposited under N₂ supply is 3 times higher, this indicates that the effective concentration is also very low. Therefore substantially no nitrogen was incorporated by supplying N₂ during deposition.

**Table 2: RMS roughness and XRD FWHMs for layers of 200 nm Ge grown epitaxially on Si with and without N₂ supply.**

| **Growth** **conditions** | **Ge** **thickness (nm)** | **RMS** **roughness (nm)** | **ω** **Ge(111)** **FWHM (s)** | **Asym. ω** **Ge FWHM (s)** |
|---|---|---|---|---|
| no N₂ beam | 199 | 0.59 | 648 | 1116 |
| N₂ beam | 192 | 0.53 | 533 | 1152 |

From the two experiments above it can be concluded that: the diffusion limiting gas (N₂) improves the smoothness of the thin epitaxial layer significantly.

At the same time, the diffusion limiting gas beam/flux is suppressing slightly the relaxation of epitaxial layer, increasing the critical thickness with about 20% in case of epitaxial grown Ge on Si.

For thick Ge layers on Si, the diffusion limiting gas beam has improved slightly the crystal quality. Moreover, a very small, almost negligible amount of diffusion limiting gas has been incorporated.

### Experiment 3: The influence of a N₂ gas beam/flux on the epitaxial growth of A1 layers on Si.

The influence of a N₂ gas on the epitaxial growth of Al on Si has been investigated for Al layers with a thickness of 6 nm.

Al epitaxy on Si(111) has been performed at a substrate temperature of around 400 °C, with and without supply of a N₂ beam/flux.

The root mean square (RMS) roughness was determined by atomic force microscopy (AFM) on 5.0 µm by 5.0 µm area. As shown in Table 3, the sample grown in the presence of N₂ beam/flux show a lower RMS value (6.7 nm) than the sample grown in the absence of N₂ (8.4 nm).

**Table 3: RMS roughness for layers of 6 nm Al grown epitaxially on Si with and without N₂ supply.**

| **Growth** **conditions** | **Al** **thickness (nm)** | **RMS** **roughness (nm)** |
|---|---|---|
| no N₂ beam | 6 | 8.4 |
| N₂ beam | 6 | 6.7 |

The present invention can be applied in different areas of semiconductor device manufacturing. While the invention is described in conjunction with forming a mono-crystalline Ge layer on a mono-crystalline Si substrate, it will be apparent to those ordinary skilled in the art that the benefits of this invention can be applied to other semiconductor materials and/or substrates as described elsewhere in the text.

The method of the invention can be suitably applied in manufacturing a CMOS device, wherein a relatively thin (<50nm) mono-crystalline semiconductor layer (e.g. Ge) is formed on a semiconductor substrate.

## Claims

1. Method for growing a layer of a mono-crystalline material on a substrate comprising
- loading a substrate having an exposed area made of a first mono-crystalline material in a process chamber,
- supplying a beam of neutral species of a second material towards the substrate in the presence of a diffusion limiting gas, such that the pressure in the process chamber is between 1x10⁻⁶ torr and 1x10⁻⁴ torr, so that the neutral species of the second material are adsorbed on the exposed area, thereby growing a mono-crystalline layer of said second material overlying and in contact with the first mono-crystalline material
wherein said diffusion limiting gas is a noble gas, molecular N₂, or a mixture thereof and wherein the second material is germanium, the beam of neutral species is formed by evaporation, and the growing is performed at a temperature between 300°C and 550°C.

2. Method according to claim 1, comprising the steps of
- loading a substrate having an exposed area made of a first mono-crystalline material in a process chamber, thereafter
- introducing said non-reactive diffusion-limiting gas into said chamber, such that the pressure in the process chamber is between 1x10⁻⁶ torr and 1x10⁻⁴ torr,
- supplying a beam of neutral species of the second material towards the substrate so that the neutral species of the second material are adsorbed on the exposed area.

3. Method according to claim 1, comprising the steps of
- loading a substrate having an exposed area made of a first mono-crystalline material in a process chamber, thereafter
- supplying a beam of neutral species of the second material towards the substrate so that the neutral species of the second material are adsorbed on the exposed area
- simultaneously with said beam of a neutral species, supplying a flux of said non-reactive diffusion-limiting gas into said chamber, such that the pressure in the process chamber is between 1x10⁻⁶ torr and 1x10⁻⁴ torr.

4. Method according to any one of claims 1 to 3, wherein before the substrate is loaded into the chamber, and before any of the steps of introducing the diffusion-limiting gas and the neutral species, a background pressure lower than 10⁻⁹ torr is created in the process chamber.

5. The method according to claim 3, wherein said flux of a diffusion-limiting gas is between 0.1 and 20sccm.

6. The method according to any of the preceding claims, wherein the first mono-crystalline material is a semiconductor material of group IV.

7. The method of any of the claims 1 to 5, wherein the first mono-crystalline material is a III-V compound semiconductor material.

8. Method for growing a layer of a mono-crystalline material on a substrate comprising
- loading a substrate having an exposed area made of a first mono-crystalline material in a process chamber,
- supplying a beam of neutral species of a second material towards the substrate in the presence of a diffusion limiting gas, such that the pressure in the process chamber is between 1x10⁻⁶ torr and 1x10⁻⁴ torr, so that the neutral species of the second material are adsorbed on the exposed area, thereby growing a mono-crystalline layer of said second material overlying and in contact with the first mono-crystalline material
wherein said diffusion limiting gas is a noble gas, molecular N₂, or a mixture thereof and wherein the second mono-crystalline material is aluminium, and the beam of neutral species is formed by evaporation.

9. Use of the method as in any of the above claims for manufacturing a CMOS device.

## Patentansprüche

1. Verfahren zum Anbau eines monokristallinen Materials auf einem Substrat, umfassend
- das Beladen eines Substrats mit einem freigelegten Bereich, bestehend aus einem ersten monokristallinen Material, in einer Verarbeitungskammer,
- das Zuführen eines Strahls einer neutralen Spezies eines zweiten Materials zum Substrat hin, in Anwesenheit eines diffusionslimitierenden Gases, so dass der Druck in der Verarbeitungskammer zwischen 1x10⁻⁶ Torr und 1x10⁻⁴ Torr beträgt, so dass die neutrale Spezies des zweiten Materials auf dem freigelegten Bereich adsorbiert wird, wodurch eine monokristalline Lage des genannten zweiten Materials, welches das erste monokristalline Material überlagert und mit diesem in Kontakt steht, angebaut wird,
wobei das genannte diffusionslimitierende Gas ein Edelgas, molekulares N₂, oder eine Mischung davon ist und wobei das zweite Material Germanium ist, der Strahl der neutralen Spezies durch Evaporation gebildet wird, und das Anbau bei einer Temperatur zwischen 300 °C und 550 °C durchgeführt wird.

2. Verfahren nach Anspruch 1, umfassend die Schritte des
- Beladens eines Substrats mit einem freigelegten Bereich, bestehend aus einem ersten monokristallinen Material in einer Verarbeitungskammer, danach
- das Einführen des genannten nichtreaktiven diffusionslimitierenden Gases in die genannte Kammer, so dass der Druck in der Verarbeitungskammer zwischen 1x10⁻⁶ Torr und 1x10⁻⁴ Torr beträgt,
- Zuführens eines Strahls einer neutralen Spezies des zweiten Materials zum Substrat hin, so dass die neutrale Spezies des zweiten Materials auf dem freigelegten Bereich adsorbiert wird.

3. Verfahren nach Anspruch 1, umfassend die Schritte des
- Beladens eines Substrats mit einem freigelegten Bereich, bestehend aus einem ersten monokristallinen Material, in einer Verarbeitungskammer, danach
- das Zuführen eines Strahls einer neutralen Spezies des zweiten Materials zum Substrat hin, so dass die neutrale Spezies des zweiten Materials auf dem freiliegenden Bereich adsorbiert wird
- gleichzeitig mit dem genannten Strahl einer neutralen Spezies das Zuführen eines Flussmittels des genannten nichtreaktiven diffusionslimitierenden Gases in die genannte Kammer, so dass der Druck in der Verarbeitungskammer zwischen 1x10⁻⁶ Torr und 1x10⁻⁴ Torr beträgt.

4. Verfahren nach einem der Ansprüche 1 bis 3, wobei bevor das Substrat in die Kammer geladen wird, und bevor einer der Schritte des Einführens des diffusionslimitierenden Gases und der neutralen Spezies, ein Hinterdruck in der Verarbeitungskammer erzeugt wird, der niedriger als 10⁻⁹ Torr ist.

5. Verfahren nach Anspruch 3, wobei das genannte Flussmittel eines diffusionslimitierenden Gases zwischen 0,1 und 20 sccm beträgt.

6. Verfahren nach einem der vorstehenden Ansprüche, wobei das erste monokristalline Material ein Halbleitermaterial der Gruppe IV ist.

7. Verfahren nach einem der Ansprüche 1 bis 5, wobei das erste monokristalline Material ein Halbleitermaterial der Verbindung III-V ist.

8. Verfahren zum Anbau einer Schicht aus monokristallinem Material auf einem Substrat, umfassend
- das Beladen eines Substrats mit einem freigelegten Bereich, bestehend aus einem ersten monokristallinen Material, in einer Verarbeitungskammer,
- das Zuführen eines Strahls einer neutralen Spezies eines zweiten Materials zum Substrat hin, in Anwesenheit eines diffusionslimitierenden Gases, so dass der Druck in der Verarbeitungskammer zwischen 1x10⁻⁶ Torr und 1x10⁻⁴ Torr beträgt, so dass die neutrale Spezies des zweiten Materials auf dem freigelegten Bereich adsorbiert wird, wodurch eine monokristalline Lage des genannten zweiten Materials, welches das erste monokristalline Material überlagert und mit diesem in Kontakt steht, angebaut wird,
wobei das genannte duffusionslimitierende Gas ein Edelgas, molekulares N₂, oder eine Mischung davon ist und wobei das zweite monokristalline Material Aluminium ist, und der Strahl der neutralen Spezies durch Evaporation gebildet wird.

9. Verwendung des Verfahrens wie nach einem der oben genannten Ansprüche zur Herstellung einer CMOS-Vorrichtung.

## Revendications

1. Procédé pour former une couche d'un matériau monocristallin sur un substrat comprenant
- la charge d'un substrat ayant une zone exposée constituée d'un premier matériau monocristallin dans une chambre de traitement,
- la délivrance d'un faisceau d'espèce neutre d'un deuxième matériau vers le substrat en présence d'un gaz limitant la diffusion, de sorte que la pression dans la chambre de traitement soit comprise entre 1x10⁻⁶ torr et 1x10⁻⁴ torr, de sorte que les espèces neutres du deuxième matériau soient adsorbées sur la zone exposée, de manière à former une couche monocristalline dudit deuxième matériau recouvrant et en contact avec le premier matériau monocristallin
dans lequel ledit gaz limitant la diffusion est un gaz noble, N₂ moléculaire, ou un mélange de ceux-ci et dans lequel le deuxième matériau est le germanium, le faisceau d'espèce neutre est formé par évaporation, et la formation est effectuée à une température comprise entre 300 °C et 550 °C.

2. Procédé selon la revendication 1, comprenant les étapes
- de charge d'un substrat ayant une zone exposée constituée d'un premier matériau monocristallin dans une chambre de traitement, puis
- d'introduction dudit gaz limitant la diffusion non réactif dans ladite chambre, de sorte que la pression dans la chambre de traitement soit comprise entre 1x10⁻⁶ torr et 1x10⁻⁴ torr,
- de délivrance d'un faisceau d'espèce neutre du deuxième matériau vers le substrat de sorte que les espèces neutres du deuxième matériau soient adsorbées sur la zone exposée.

3. Procédé selon la revendication 1, comprenant les étapes de
- charge d'un substrat ayant une zone exposée constituée d'un premier matériau monocristallin dans une chambre de traitement, puis
- délivrance d'un faisceau d'espèce neutre du deuxième matériau vers le substrat de sorte que les espèces neutres du deuxième matériau soient adsorbées sur la zone exposée
- simultanément avec ledit faisceau d'une espèce neutre, délivrance d'un flux dudit gaz limitant la diffusion non réactif dans ladite chambre, de sorte que la pression dans la chambre de traitement soit comprise entre 1x10⁻⁶ torr et 1x10⁻⁴ torr.

4. Procédé selon l'une quelconque des revendications 1 à 3, dans lequel, avant que le substrat soit chargé dans la chambre, et avant l'une quelconque des étapes d'introduction du gaz limitant la diffusion et de l'espèce neutre, une pression ambiante inférieure à 10⁻⁹ torr est créée dans la chambre de traitement.

5. Procédé selon la revendication 3, dans lequel ledit flux d'un gaz limitant la diffusion est compris entre 0,1 et 20 sccm.

6. Procédé selon l'une quelconque des revendications précédentes, dans lequel le premier matériau monocristallin est un matériau semi-conducteur du groupe IV.

7. Procédé de l'une quelconque des revendications 1 à 5, dans lequel le premier matériau monocristallin est un matériau semi-conducteur de composé III à V.

8. Procédé pour former une couche de matériau monocristallin sur un substrat comprenant
- la charge d'un substrat ayant une zone exposée constituée d'un premier matériau monocristallin dans une chambre de traitement,
- la délivrance d'un faisceau d'espèce neutre d'un deuxième matériau vers le substrat en présence d'un gaz limitant la diffusion, de sorte que la pression dans la chambre de traitement soit comprise entre 1x10⁻⁶ torr et 1x10⁻⁴ torr, de sorte que les espèces neutres du deuxième matériau soient adsorbées sur la zone exposée, de manière à former une couche monocristalline dudit deuxième matériau recouvrant et en contact avec le premier matériau monocristallin
dans lequel ledit gaz limitant la diffusion est un gaz noble, N₂ moléculaire, ou un mélange de ceux-ci et dans lequel le deuxième matériau monocristallin est l'aluminium, et le faisceau d'espèce neutre est formé par évaporation.

9. Utilisation du procédé selon l'une quelconque des revendications ci-dessus pour fabriquer un dispositif CMOS.
